# EUROPEAN PATENT APPLICATION

(11) **EP 4 848 950 A1**
(43) Date of publication of application: **02.12.2026**
(21) Application number: 25762386.8
(22) Date of filing: 27.02.2025
(51) Int. Cl.: H10H 20/855, H10H 20/851, H10H 20/853, F21V 23/00, F21K 9/64, F21K 9/237, F21K 9/69, F21K 9/68, F21Y 115/10

(54) **LIGHT-EMITTING DEVICE**

(30) Priority: 27.02.2024 US 202463558332 P; 26.02.2025 US 202519064358
(71) Applicant: Seoul Semiconductor Co., Ltd., Gyeonggi-do 15429 (KR)
(72) Inventor: SON, Junghun, Ansan-Si Gyeonggi-do 15429 (KR); KIM, Hyein, Ansan-Si Gyeonggi-do 15429 (KR); HWANG, Sungki, Ansan-Si Gyeonggi-do 15429 (KR)
(74) Representative: Isarpatent
(86) International application number: PCT/KR2025/002732
(87) International publication number: WO 2025/183469

(57) **Abstract**

Disclosed is a light emitting device. The light emitting device includes: a substrate; a light emitting unit disposed on the substrate; a wavelength converter disposed on the light emitting unit; an optical unit disposed on the wavelength converter; and a barrier disposed on the substrate and covering side surfaces of the light emitting unit, the wavelength converter, and the optical unit. The optical unit includes an optical base and an optical pattern composed of recess-protrusion structures formed on at least one surface of the optical base.

## Description

### [Technical Field]

Embodiments of the present invention relate to a light emitting device.

### [Background Art]

A light emitting diode is a semiconductor device that emits light through recombination of electrons and holes, and has recently been used in many fields, such as displays, vehicular lamps, general lighting, and the like. With advantages of long lifespan, low power consumption, and fast response, light emitting diodes are applied to various fields, such as vehicular lamps, displays, and the like. For example, light emitting diodes are also applied to head-mounted displays (HMDs) and are widely applied to vehicular headlamps due to their excellent straightness of light.

For devices requiring precise control of light radiation, such as headlamps and HMDs, it is necessary to subdivide a radiation region of light. In addition, precise control of light radiation requires that each light emitting diode or a light emitting device, such as a chip or package including light emitting diodes, have a narrow beam angle.

### [Disclosure]

### [Technical Problem]

Embodiments of the present invention provide a light emitting device that has narrower beam angle than a light emitting diode.

Embodiments of the present invention provide a light emitting device that has not only a narrow beam angle but also high luminance or high luminous intensity.

Embodiments of the present invention provide a light emitting device that has uniform luminance.

Embodiments of the present invention provide a light emitting device that has uniform luminance within a beam angle by reducing brightness deviation between a center and a periphery of the beam angle.

Embodiments of the present invention provide a light emitting device with reduced chromatic aberration.

Embodiments of the present invention provide a light emitting device with improved reliability through improvement in bonding strength.

### [Technical Solution]

In accordance with an aspect of the present invention, there is provided a light emitting device including: a substrate; a light emitting unit disposed on the substrate; a wavelength converter disposed on the light emitting unit; an optical unit disposed on the wavelength converter; and a barrier disposed on the substrate and covering side surfaces of the light emitting unit, the wavelength converter, and the optical unit. The optical unit may include an optical base and an optical pattern composed of recess-protrusion structures formed on at least a surface of the optical base.

The optical pattern may be formed on an upper surface of the optical base.

The optical pattern may be formed on a lower surface of the optical base.

The optical pattern may be formed on an upper surface and a lower surface of the optical base.

The optical pattern may include a first optical pattern and a second optical pattern. The first optical pattern may be formed on an upper surface of the optical base and the second optical pattern may be formed on an upper surface of the first optical pattern. At least one of the first optical unit and the second optical unit comprises at least a material different from that of the other.

The first optical pattern and the second optical pattern may include side surfaces with different inclinations in cross-sectional view.

The optical base and the first optical pattern may be formed of the same material and may be integrally formed with each other.

A side surface of the optical pattern may comprise planes having different inclinations in cross-sectional view.

An adhesive may be formed in at least one of a region between the light emitting unit and the wavelength conversion material or a region between the wavelength conversion material and the optical unit.

An upper surface of the barrier may be placed collinear with an upper surface of the optical base.

An upper surface of the barrier may be placed higher than the optical pattern.

An upper surface of the barrier may have a height gradually increasing from an outer side of the barrier to an inner side thereof.

The barrier may cover an outer surface of the optical pattern adjacent to a periphery of an upper surface of the optical base.

The barrier may include a light reflective material.

The light emitting unit may include a growth substrate formed to face the wavelength converter. The refractive indices may decrease in the order of the growth substrate of the light emitting unit, the wavelength converter, and the optical unit.

The light emitting device may have a narrower beam angle than the light emitting unit.

The light emitting device may have a beam angle of 60 degrees to 100 degrees.

In accordance with another aspect of the present invention, there is provided a light emitting device including: a substrate; a light emitting unit disposed on the substrate; a wavelength converter disposed on the light emitting unit; an optical unit disposed on the wavelength converter; and a barrier. The barrier may be disposed on the substrate to cover side surfaces of the light emitting unit, the wavelength converter and the optical unit. The optical unit may include a first optical unit and a second optical unit disposed on the first optical unit. The second optical unit may include a second optical base disposed on the first optical unit and an optical pattern formed on an upper surface of the second optical base.

At least one of the first optical unit and the second optical unit may comprise at least a material different from that of the other.

In accordance with a further aspect of the present invention, there is provided a vehicular lamp including a main body and a lamp mounted on at least a surface of the main body, the lamp including a plurality of light emitting units arranged thereon, a wavelength converter covering an upper surface of at least a light emitting unit of the light emitting units, and an optical unit including an optical pattern composed of recess-protrusion structures formed on at least a surface of the optical unit. Each of the plurality of light emitting units may be independently driven.

Embodiments of the present invention provide a light emitting device that can reduce beam angle of light to allow precise light irradiation.

Embodiments of the present invention provide a light emitting device that can reduce beam angle to improve luminance.

### [Brief Description of Drawings]

FIG. 1 is a schematic sectional view of a light emitting device according to a first embodiment of the present invention.
FIG. 2 is an experimental result to check change in beam angle and luminance of a light emitting device depending on a structure of an optical pattern of an optical unit according to the present invention.
FIG. 3 is a graph depicting light spectra of a light emitting device depending on the structure of the optical pattern of the optical unit according to the present invention.
FIG. 4 is a beam angle characteristics graph depicting a light emission pattern depending on the structure of the optical pattern of the optical unit according to the present invention.
FIG. 5 to FIG. 7 are exemplary views illustrating a method of manufacturing the light emitting device according to the first embodiment of the present invention.
FIG. 8 to FIG. 10 are exemplary views illustrating another method of manufacturing the light emitting device according to the first embodiment of the present invention.
FIG. 11 is a schematic sectional view of a light emitting device according to a second embodiment of the present invention.
FIG. 12 is a schematic sectional view of a light emitting device according to a third embodiment of the present invention.
FIG. 13 is a schematic sectional view of a light emitting device according to a fourth embodiment of the present invention.
FIG. 14 is a schematic sectional view of a light emitting device according to a fifth embodiment of the present invention.
FIG. 15 is a schematic sectional view of a light emitting device according to a sixth embodiment of the present invention.
FIG. 16 is a schematic sectional view of a light emitting device according to a seventh embodiment of the present invention.
FIG. 17 is a schematic sectional view of a light emitting device according to an eighth embodiment of the present invention.
FIG. 18 is a schematic sectional view of a light emitting device according to a ninth embodiment of the present invention.
FIG. 19 is an exemplary view of a vehicle including a light emitting device according to an embodiment of the present invention.

### [Mode for Invention]

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," or the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), or the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, or the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

Hereinafter, light emitting devices according to the present invention will be described in detail with reference to the drawings.

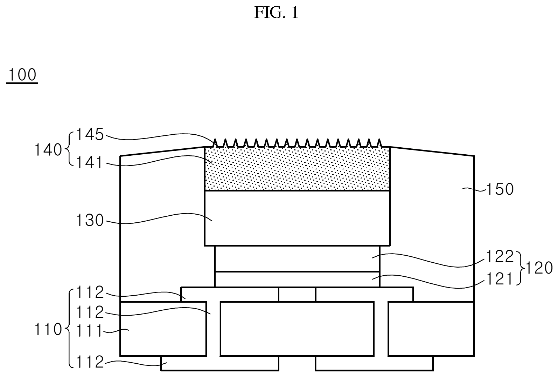

FIG. 1 is a schematic sectional view of a light emitting device according to a first embodiment of the present invention.

Referring to FIG. 1, a light emitting device 100 according to a first embodiment may include a substrate 110, a light emitting unit 120, a wavelength converter130, an optical unit 140, and a barrier 150.

The substrate 110 may include a substrate base 111 and an electrically conductive pattern 112.

The substrate base 111 may be formed of at least a material selected from among a phenolic, an epoxy, a polyimide, and ceramics. That is, the substrate base 111 may be formed of an insulating material. In addition, the substrate base 111 may include a metal layer and an insulating layer formed on a surface of the metal layer. For example, the insulating layer may be formed of an insulating resin or an oxide. That is, the substrate base 111 may be formed in a structure that can be insulated from the electrically conductive pattern 112. However, it should be understood that the substrate base 111 is not limited to the materials and structure described above, and may be formed of various materials or in various structures that can be insulated from the electrically conductive pattern 112.

The electrically conductive pattern 112 may be formed on upper and lower surfaces of the substrate base 111. In addition, the electrically conductive pattern 112 may be further formed on inner or side surfaces of the substrate base 111 to electrically connect the electrically conductive pattern 112 formed on the upper surface of the substrate base 111 to the electrically conductive pattern 112 formed on the lower surface of the substrate base 111. The electrically conductive pattern 112 may be formed of any electrically conductive material. By way example, the electrically conductive pattern 112 may be formed of copper.

The electrically conductive pattern 112 of the substrate 110 is electrically connected to the light emitting unit 120 and the substrate 110 can supply electric power to the light emitting unit 120 through the electrically conductive pattern 112.

The light emitting unit 120 can generate and emit light by receiving electric power supplied from the substrate 110. According to this embodiment, the light emitting unit 120 may include a light emitting structure 121 and a growth substrate 122.

The light emitting structure 121 generate light upon receiving electric power. For example, the light emitting structure 121 may include a first semiconductor layer, a second semiconductor layer, and an active layer.

The first semiconductor layer may be formed of a compound semiconductor, such as a Group III-V semiconductor compound, a Group II-VI semiconductor compound, and the like. For example, the first semiconductor layer may be an n-type semiconductor layer doped with an n-type dopant.

The second semiconductor layer may be formed of a compound semiconductor, such as a Group III-V semiconductor compound, a Group II-VI semiconductor compound, and the like. For example, the second semiconductor layer may be a p-type semiconductor layer doped with a p-type dopant.

By way of example, the first semiconductor layer is an n-type semiconductor layer and the second semiconductor layer is a p-type semiconductor layer. Alternatively, the first semiconductor layer may be a p-type semiconductor layer and the second semiconductor layer may be an n-type semiconductor layer.

The active layer may be formed between the first semiconductor layer and the second semiconductor layer.

The active layer refers to a layer in which electrons injected through the first semiconductor layer recombine with holes injected through the second semiconductor layer, and can generate light through recombination of the electrons and the holes. Alternatively, the active layer can generate light through recombination of holes injected through the first semiconductor layer and electrons injected through the second semiconductor layer.

The active layer may be formed in any one of a single well structure, a multi-well structure, a single quantum well structure, a multi-quantum well (MQW) structure, a quantum dot structure, or a quantum line structure.

Light generated by the active layer can be emitted to the outside of the light emitting structure 121 through upper and side surfaces of the light emitting structure 121. In addition, light generated by the active layer may be emitted to the outside of the light emitting structure 121 through a lower surface of the light emitting structure 121.

Depending on the composition of the first semiconductor layer, the second semiconductor layer, and the active layer, the type of light generated therein may vary. For example, the light emitting structure 121 may generate and emit blue light or UV light. The type of light emitted from the light emitting structure 121 is not limited to blue light and UV light, and the light emitting structure 121 may emit light with various wavelengths.

The growth substrate 122 may be a substrate for growth of semiconductor layers. For example, the growth substrate 122 may be formed of a material selected from among sapphire (Al₂O₃), SiC, GaAs, GaN, ZnO, Si, GaP, InP, and Ge.

The light emitting unit 120 may be electrically connected to the electrically conductive pattern 112 of the substrate 110 via electrodes.

According to an embodiment, the light emitting unit 120 may be a light emitting diode chip. The light emitting unit 120 may have a structure in which an electrode electrically connected to the first semiconductor layer is placed in the same direction as an electrode electrically connected to the second semiconductor layer. For example, the light emitting unit 120 may be a light emitting diode chip of a flip chip structure.

The light emitting unit 120 may be formed on the upper surface thereof with a wavelength converter 130.

The wavelength converter 130 may include a light transmitting unit and a wavelength conversion material dispersed within the light transmitting unit. The light transmitting unit may be formed of a material through which light emitted from the light emitting unit 120 is transmitted. For example, the light transmitting unit may be formed of a polymer resin, such as a silicone resin, and a ceramic material, such as glass and alumina. In addition, the light transmitting unit may have a transmittance of 70% or more. Thus, the wavelength converter 130 or the light transmitting unit of the wavelength converter 130 may absorb less light emitted from the light emitting unit 120, thereby improving luminous efficacy of the light emitting device 100. In addition, the light transmitting unit may have an index of refraction of 1.3 to 2. Here, a light path can be adjusted by adjusting the index of refraction of the light transmitting unit, whereby the beam angle of the light emitting device can be adjusted to increase luminance or luminous intensity. The wavelength conversion material may include any material, such as phosphors or quantum dots, which emits light upon excitation by light emitted from the light emitting unit 120.

For example, the wavelength converter 130 may include phosphor-in-silicone (PIS) with phosphors dispersed in a silicone resin, phosphor-in-glass (PIG) with phosphors dispersed in glass, or phosphor-in-ceramic (PIC) with phosphors dispersed in ceramic. In addition, the wavelength converter 130 may be in the form of a film having an average thickness tolerance of about 10%. A greater thickness of the wavelength converter 230 can indicate a greater traveling length of light. That is, as the thickness deviation of the wavelength converter 230 increases, deviation in traveling length of light passing through the wavelength converter 230 also increases. A wavelength conversion rate can increase with increasing traveling length of light within the wavelength converter 230 and can decrease with decreasing traveling length of the light. Accordingly, as the thickness deviation of the wavelength converter 230 decreases, a difference between the light traveling path and the wavelength conversion rate can be reduced, thereby reducing chromatic aberration while improving color purity.

The optical unit 140 may be formed on top of the wavelength converter 130.

The optical unit 140 may be formed of a light transmitting material. For example, the optical unit 140 may be formed of a light transmitting material, such as sapphire, glass, a silicone resin, alumina, or a urethane. The optical unit 140 may have a light transmittance of 70% or more. Thus, the optical unit 140 may absorb less light generated by the light emitting unit 120, thereby improving luminous efficacy of the light emitting device 100. In addition, the optical unit 140 may have an index of refraction of 1.4 to 2. The optical unit 140 having such an index of refraction can reduce the beam angle of the light emitting device 100 while improving luminance or luminous intensity thereof by changing the light path thereof.

According to the embodiment, the optical unit 140 may have an optical pattern 145 formed on at least a surface of an upper surface or a lower surface thereof. That is, the optical unit 140 has the optical pattern 145 formed on the upper surface thereof, which corresponds to a light exit surface. Referring to FIG. 1, the optical unit 140 according to this embodiment may include an optical base 141 and an optical pattern 145 formed on an upper surface of the optical base 141.

For example, the optical pattern 145 may be composed of a plurality of structures having a single vertex at the top thereof, such as a conical shape and a pyramid shape including a triangular pyramid shape, a quadrangular pyramid shape, a pentagonal pyramid shape, and the like. When the optical pattern 145 has a vertex, the beam angle of the light emitting device 100 can be reduced with decreasing interior angle at the vertex. In addition, as the beam angle of the light emitting device 100 is reduced, the luminance of the light emitting device 100 can be improved.

In addition, the optical pattern 145 may be composed of a plurality of structures each having a flat upper surface, such as a truncated cone shape, a prismoid shape, a cylinder shape or prism shape.

The beam angle of the light emitting device 100 may be adjusted by adjusting an interior angle of the vertices, the shapes of the side surfaces and the upper surface, which correspond to light exit surface, of the structures of the optical pattern 145.

The plurality of structures constituting the optical pattern 145 may be connected to each other to be continuously formed or may be spaced apart from each other by a certain distance. Further, uniformity in luminance or luminous intensity of the light emitting device 100 can be improved by adjusting a distance between the plurality of structures of the optical pattern 145.

The optical pattern 145 of the optical unit 140 may be formed by dry etching or wet etching the optical unit 140. In addition, the optical pattern 145 or the optical unit 140 formed with the optical pattern 145 may be formed by at least a process selected from among an injection process, a stamping process, a molding process, an imprint process, and a photolithography process.

According to an embodiment, the upper surface of the optical base 141 corresponding to the upper surface of the optical unit 140 and the optical pattern 145 formed on the upper surface of the optical base 141 constitute a light exit surface of the light emitting device 100.

According to this embodiment, the optical pattern 145 of the optical unit 140 can reduce the beam angle of light. That is, the beam angle of light emitted from the light emitting device 100 can be narrower when the optical pattern 145 is formed on the optical unit 140 than when the optical pattern 145 is not formed on the optical unit 140. Furthermore, the optical pattern 145 can reduce total internal reflection of light passing through the light exit surface of the light emitting device 100, thereby increasing light quantity while improving luminous efficacy.

In addition, according to this embodiment, at least one of the light emitting unit 120, the wavelength converter 130, and the optical unit 140 of the light emitting device 100 may have a different index of refraction. For example, the light emitting unit 120, the wavelength converter 130, and the optical unit 140 may have different indices of refraction than neighboring components.

Furthermore, the index of refraction may decrease in the order of the light emitting unit 120, the wavelength converter 130, and the optical unit 140. That is, as light passes through the growth substrate 122 of the light emitting unit 120, the wavelength converter 130, and the optical unit 140, the light passes through a region in which the index of refraction is gradually reduced. Since the index of refraction decreases in the order of the light emitting unit 120, the wavelength converter 130, and the optical unit 140, light loss due to Fresnel reflection at interfaces therebetween also decreases. That is, the light emitting device 100 according to this embodiment is formed such that the index of refraction decreases in a light traveling direction of the light emitting device 100, thereby reducing light loss due to Fresnel reflection while improving light extraction efficiency.

Alternatively, materials for the light emitting unit 120, the wavelength converter 130, and the optical unit 140 may be selected such that components having a high index of refraction and components having a low index of refraction are alternately arranged. For example, the light emitting unit 120 may have an index of refraction of 1.7 or more, the wavelength converter 130 adjacent to the light emitting unit 120 may have an index of refraction of 1.4 to 1.6, and the optical unit 140 adjacent to the wavelength converter 130 may have an index of refraction of 1.5 to 1.8. When components having a high index of refraction and components having a low index of refraction are alternately arranged, each component can transmit or totally reflect light incident at an angle in a certain range. Thus, the wavelength converter 130 can adjust the beam angle of the light emitting device 100 while improving light extraction efficiency by adjusting the light traveling direction through such a Bragg reflection effect.

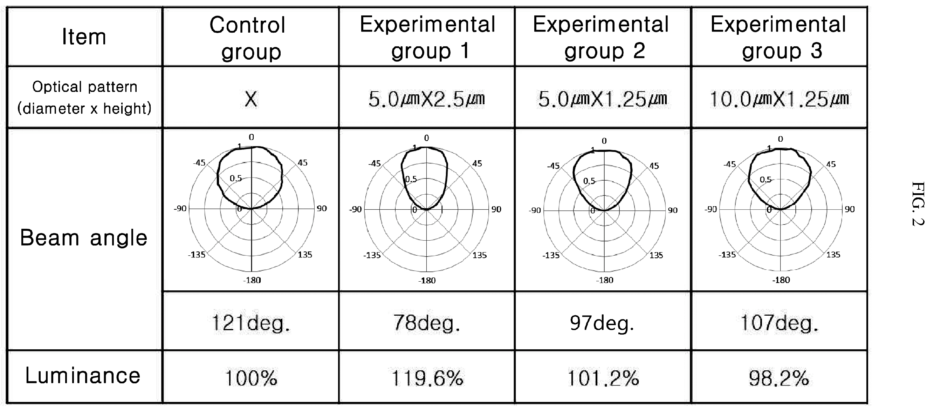

FIG. 2 to FIG. 4 show experimental results with respect to the beam angle and luminance of the light emitting device according to the embodiment of the present invention. More specifically, FIG. 2 to FIG. 4 show experimental results depending on the structure of the optical unit 140 and the optical pattern 145 of the light emitting device 100 shown in FIG. 1.

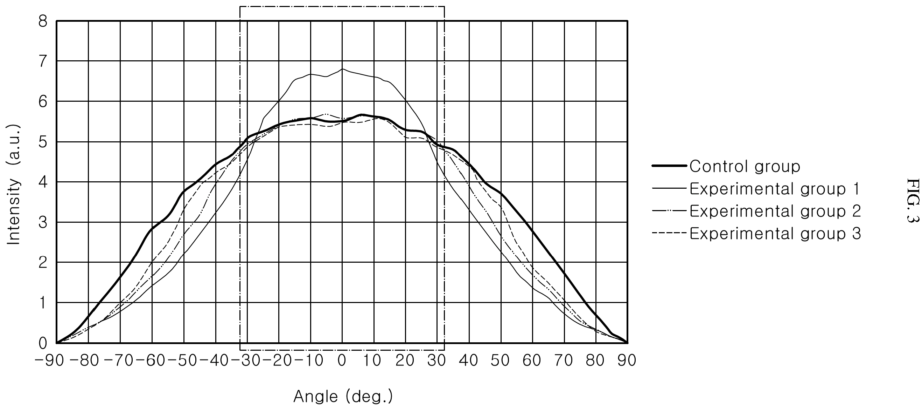

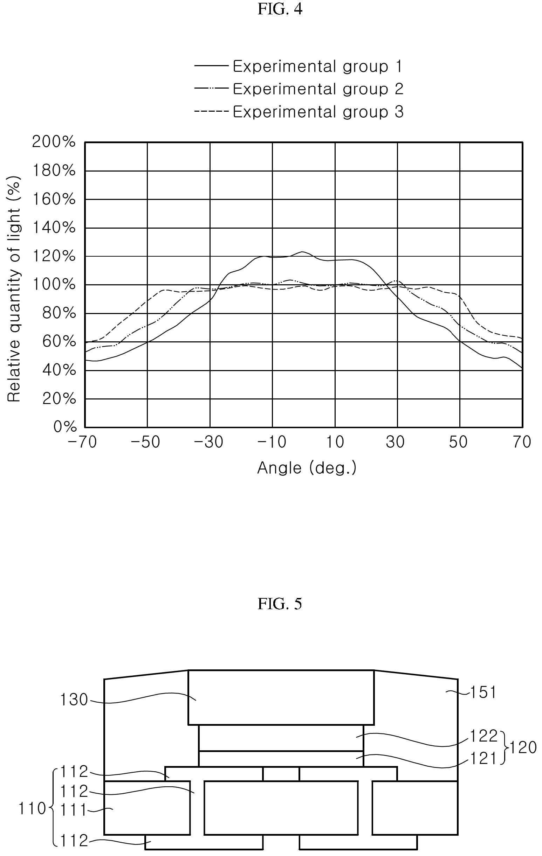

FIG. 2 shows an experimental result to confirm change in beam angle and luminance of the light emitting device depending on the structure of the optical pattern 145 of the optical unit 140 according to the present invention. FIG. 3 shows a spectrum of light emitted from the light emitting device depending on the structure of the optical pattern 145 of the optical unit 140 according to the present invention. Furthermore, FIG. 4 is a beam angle characteristics graph showing a light emission pattern depending on the structure of the optical pattern 145 of the optical unit 140.

A control group refers to a light emitting device with no optical unit formed thereon and Experimental groups 1 to 3 refer to light emitting devices each formed with an optical unit 140 having an optical pattern 145.

Referring to FIG. 2, all of Experimental groups 1 to 3 each including the optical unit 140 having the optical pattern 145 formed thereon have a narrower beam angle than the control group. In addition, Experimental groups 1 and 2 have higher luminance than the control group. That is, the optical unit 140 having the optical pattern 145 formed thereon can reduce the beam angle of the light emitting device while improving luminance thereof.

Comparing Experimental group 1 and Experimental group 2, as the height of the optical pattern 145 increases, the beam angle decreases and the luminance increases. Furthermore, comparing Experimental group 2 and Experimental group 3, as the diameter of the optical pattern 145 decreases, the beam angle decreases and the luminance increases. That is, in Experimental groups 1 to 3, as an interior angle formed between two sides connected to the vertex of the optical pattern 145 in cross-sectional view decreases, the light emitting device can have a reduced beam angle while improving luminance thereof.

In addition, Experimental group 1 has the narrowest beam angle among the experimental groups. Experimental group 1 has a beam angle of about 80 degrees and luminance that is about 20% higher than luminance of the control group. Experimental group 1 having a beam angle of about 80 degrees can increase the luminance by about 20%, as compared with the control group.

If the height of the optical pattern 145 is too low, the effect of reducing the beam angle of the light emitting device 100 is reduced. In addition, if the height of the optical pattern 145 is too great, the light emitting device has an increased light path, causing increase in quantity of light trapped within the optical unit 140, whereby the light emitting device 100 can suffer from deterioration in luminance through increases in light loss. Accordingly, the optical pattern 145 according to this embodiment may have a height that is 0.5% to 10% of the height of the optical base 141.

When the optical pattern 145 has a single vertex, a relationship between the beam angle y and the interior angle x at the vertex is represented by Equation 1. <Equation 1> $50.3073 ln \left(x\right) - 121.5 \leq y \leq 61.4867 ln \left(x\right) - 148.5 ,$
where x may range from 30 degrees to 80 degrees.

According to the embodiment, the beam angle of the light emitting device may decrease with increasing height of the optical pattern 145 and with decreasing diameter of the optical pattern 145.

A relationship between the beam angle y and the height a of the optical pattern 145 is represented by Equation 2. <Equation 2> $1.44 {a}^{2} - 19.08 a + 108.9 \leq y \leq 1 {. 76 a}^{2} - 23.32 a + 133.1$

In addition, a relationship between the beam angle y and the diameter b of the optical pattern 145 is represented by Equation 3. <Equation 3> $- 0.036 {b}^{2} - 2.34 b + 76.5 \leq y \leq - 0.044 {b}^{2} - 2.86 b + 93.5 ,$
where y may range from 40 degrees to 120 degrees.

If the optical unit 140 according to the embodiment shown in FIG. 1 is too thin, the effect of narrowing the beam angle of the light emitting device is reduced. If the optical unit 140 is too thick, the quantity of light trapped and lost within the optical unit 140 due to increase in light path can increase, thereby reducing luminance of the light emitting device 100. For example, the thickness of the optical unit 140 may be 0.5 times to 1.5 times the thickness of the light emitting unit 120.

The barrier 150 may be formed on the substrate 110 to cover side surfaces of the light emitting unit 120, the wavelength converter 130, and the optical unit 140.

Here, an inner wall of the barrier 150 may closely contact the side surface of the optical unit 140. Referring to FIG. 1, the side surface of the optical unit 140 may be flat whereas the side surface of the optical unit 140 may have a curved or uneven structure. Here, the inner wall of the barrier 150 may have a structure corresponding to the structure of the side surface of the optical unit 140 that closely contacts the inner wall of the barrier 150.

The barrier 150 may be formed of an insulating material. For example, the barrier 150 may be formed of an insulating resin or ceramic material, such as a silicone resin, a polyimide resin, a urethane resin, a polymer resin, and the like. In this embodiment, the barrier 150 may include a light reflective material. For example, the light reflective material may be selected from a variety of light reflective materials such as TiO₂, Ba₂Ti₉O₂₀, BaSO₄, SiO₂, CaCO₃, ZnO, CaCO₃, and the like.

The barrier 150 reflects light emitted from the side surfaces of the light emitting unit 120, the wavelength converter 130, and the optical unit 140 such that the light can be emitted from the light emitting device 100 through the upper surface of the optical unit 140 and the optical pattern 145. For example, the barrier 150 may have a reflectivity of 70% or more. In addition, the barrier 150 may have a transmittance of less than 30%.

**[Table 1] Comparison of light quantity of control group and Experimental groups**

| | Control group | Experimental group 1 | Experimental group 2 | Experimental group 3 |
|---|---|---|---|---|
| Total area | 128 | 115 | 113 | 117 |
| Area at beam angle of -30 degrees to 30 degrees | 70 | 79 | 71 | 69 |
| Area at beam angle of -30 degrees to 30 degrees relative to total area | 55% | 69% | 62% | 59% |
| Total area compared to control group | 100% | 89% | 88% | 91% |
| Area at beam angle of -30 degrees to 30 degrees relative to control group | - | 112% | 100% | 98% |

Referring to Table 1 and FIG. 3, Experimental groups 1 and 2 have larger areas at a beam angle of -30 degrees to 30 degrees relative to the total area than the control group. In addition, Experimental groups 1 and 2 also have larger areas at a beam angle of -30 degrees to 30 degrees than the control group. That is, Experimental groups 1 and 2 also have higher quantities of light at a beam angle of -30 degrees to 30 degrees than the control group. FIG. 4 is a beam angle characteristics graph showing a light emission pattern depending on the structure of the optical pattern 145 of the optical unit 140 according to the present invention. Here, the x-axis indicates the beam angle of Experimental groups 1 to 3 and the y-axis indicates relative light quantity relative to the quantity of light of the control group.

Referring to FIG. 4, all of Experimental groups 1 to 3 have a relative light quantity of 85% to 140% at a beam angle of -30 degree to 30 degree. In particular, Experimental group 1 has a relative light quantity of 120% or more at 0 degrees.

From Table 1, FIG. 3, and FIG. 4, it can be seen that the optical unit 140 having the optical pattern 145 thereon can reduce the beam angle of the light emitting device, thereby improves luminance thereof through increase in quantity of light within the beam angle range.

As such, the light emitting device 100 according to this embodiment can reduce the beam angle using not only the optical pattern 145 but also the barrier 150. That is, with the barrier 150 and the optical pattern 145, the light emitting device 100 may have a narrower beam angle than the light emitting unit 120. For example, when a light emitting diode chip corresponding to the light emitting unit 120 has a beam angle of about 120 degrees, the light emitting device 100 according to this embodiment may have a beam angle of about 60 degrees to about 100 degrees. Furthermore, the light emitting device 100 may have a beam angle of about 70 degrees to about 80 degrees.

In addition, as the beam angle of light decreases, the light emitting device 100 according to this embodiment can improve luminance by concentrating the light within a predetermined range.

In the following description of various embodiments, repeated description of the same or like components will be omitted or briefly given. For example, repeated description of the same materials, structures, effects, and the like of the same or like components will be omitted or briefly given. Accordingly, for detailed description of the omitted or briefly described components, refer to the description of the above embodiment.

FIG. 5 to FIG. 7 are exemplary views illustrating a method of manufacturing the light emitting device according to the first embodiment of the present invention.

Referring to FIG. 5, a light emitting unit 120, a wavelength converter 130, and a first barrier 151 are formed on a substrate 110.

First, the light emitting unit 120 and the wavelength converter 130 may be formed on the substrate 110 to be sequentially stacked thereon. Then, the first barrier 151 is formed to cover the light emitting unit 120 and the wavelength converter 130. The first barrier 151 covers side surfaces of the light emitting unit 120 and the wavelength converter 130 without covering an upper surface of the wavelength converter 130. That is, an upper surface of the first barrier 151 is placed at the same height as the upper surface of the wavelength converter 130.

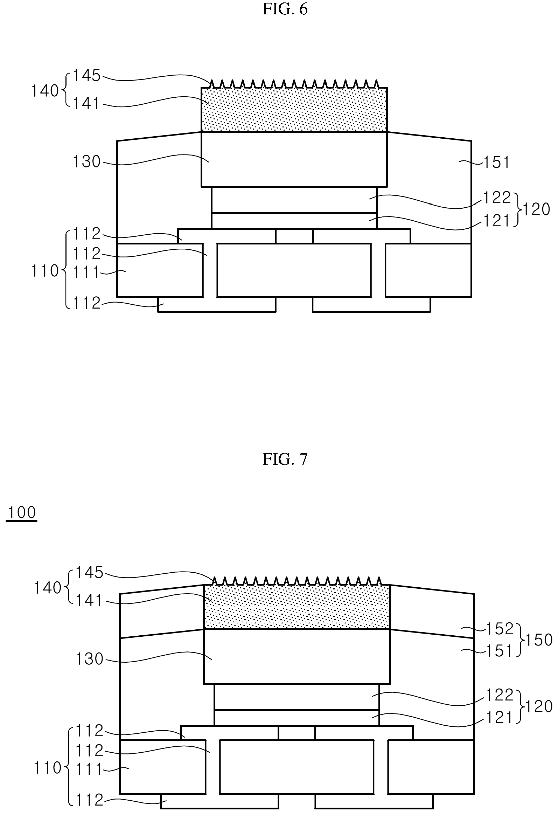

Referring to FIG. 6, an optical unit 140 may be formed on the upper surface of the wavelength converter 130.

The optical unit 140 including an optical pattern 145 may be separately formed. That is, the optical unit 140 may be separately formed and mounted on the upper surface of the wavelength converter 130. Alternatively, the optical unit 140 including the optical pattern 145 may be formed by forming an optical material on the upper surface of the wavelength converter 130, followed by patterning the optical material.

Referring to FIG. 7, a second barrier 152 may be formed on the first barrier 151. The second barrier 152 may be formed to cover a side surface of the optical unit 140 while exposing an upper surface of the optical unit 140.

In this embodiment, the first barrier 151 and the second barrier 152 correspond to the barrier 150 shown in FIG. 1.

The first barrier 151 and the second barrier 152 may include the same material. When the first barrier 151 and the second barrier 152 are formed of the same material or include the same material, reliability of the light emitting device 100 can be improved by preventing external substances, such as moisture and dust, from penetrating into the light emitting device 100 due to high bonding strength between the same materials.

Referring to FIG. 7, outer surfaces of the first barrier 151 and the second barrier 152 are placed on the same vertical line. However, it should be understood that the present invention is not limited thereto. The first barrier 151 and the second barrier 152 may be formed such that the outer surfaces of the first barrier 151 and the second barrier 152 are at least partially placed on different vertical lines to regulate the path of light emitted through the outer surfaces thereof. Accordingly, the first barrier 151 and the second barrier 152 may adjust the beam angle of the light emitting device 100 by adjusting the path of light that is transmitted and emitted through the side surfaces thereof instead of being reflected thereby.

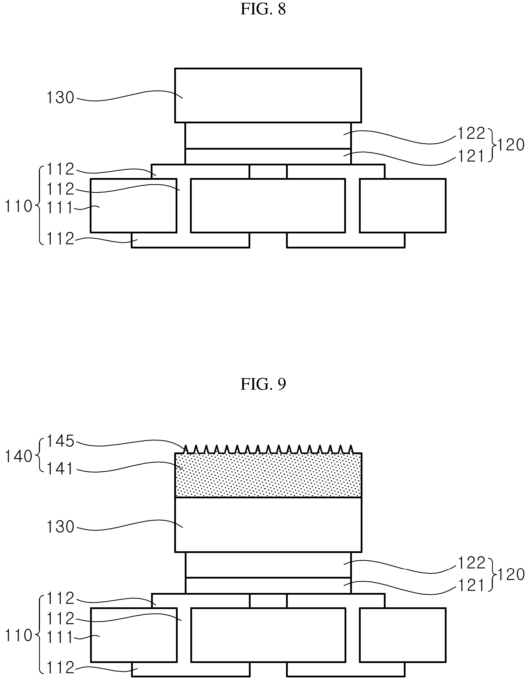

FIG. 8 to FIG. 10 are exemplary views illustrating another method of manufacturing the light emitting device according to the first embodiment of the present invention.

Referring to FIG. 8, the light emitting unit 120 and the wavelength converter 130 may be formed to be sequentially stacked on the substrate 110.

Referring to FIG. 9, the optical unit 140 having the optical pattern 145 may be formed on the wavelength converter 130. The optical unit 140 including the optical pattern 145 may be separately formed. That is, the optical unit 140 may be separately formed and mounted on the upper surface of the wavelength converter 130. Alternatively, the optical unit 140 including the optical pattern 145 may be formed by forming an optical material on the upper surface of the wavelength converter 130, followed by patterning the optical material.

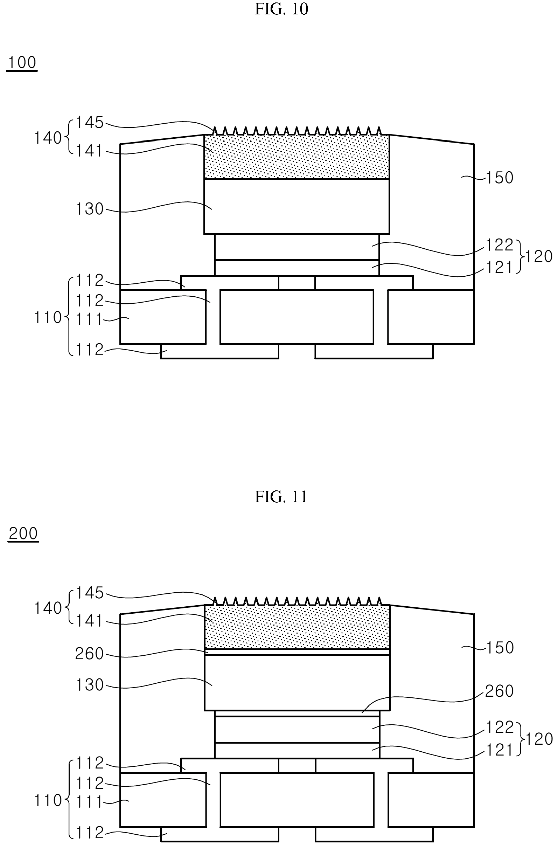

Referring to FIG. 10, the barrier 150 may be formed on the substrate 110. The barrier 150 covers the side surfaces of the light emitting unit 120, the wavelength converter 130, and the optical unit 140 while exposing the upper surface of the optical unit 140.

In the method of manufacturing the light emitting device 100 shown in FIG. 5 to FIG. 10, when forming each component, an adhesive including a light transmissive bonding material may be formed between the components, as needed. For example, the light transmissive bonding material may be used for bonding the light emitting unit 120 and the wavelength converter 130 or for bonding the wavelength converter 130 and the optical unit 140. The light transmissive bonding material may include a thermosetting resin, such as a silicone resin, an epoxy resin, or a urethane resin, or may include a UV-curable resin. In addition, the light transmissive bonding material may have a transmittance of 50% or more. Thus, the light transmissive bonding material can minimize deterioration in luminous efficacy of the light emitting device 100 and can improve reliability of the light emitting device 100 by improving bonding strength between the components constituting the light emitting device 100.

Alternatively, the adhesive may be omitted from the light emitting device 100. Since the light emitting device not including the adhesive has a shorter light path than the light emitting device including the adhesive, light absorption inside the light emitting device 100 can be reduced, thereby improving light extraction efficiency of the light emitting device 100.

FIG. 11 is a sectional view of a light emitting device according to a second embodiment of the present invention.

Referring to FIG. 11, a light emitting device 200 according to a second embodiment may include a substrate 110, a light emitting unit 120, a wavelength converter 130, an optical unit 140, and a barrier 150.

Further, the light emitting device 200 according to the second embodiment may include adhesives 260 interposed between the light emitting unit 120 and the wavelength converter 130 and between the wavelength converter 130 and the barrier 150.

Depending on the material of the wavelength converter 130, the wavelength converter 130 can exhibit weak bonding strength with respect to the light emitting unit 120 or the optical unit 140. For example, when the wavelength converter 130 includes PIS, bonding strength of the wavelength converter 130 can be improved by a curing process. On the other hand, when the wavelength converter 130 is PIG or PIC, the bonding strength of the wavelength converter 130 to the light emitting unit 120 and to the optical unit 140 may be low, and additional bonding strength may be required.

The adhesive 260 can improve bonding strength between the wavelength converter 130 and the light emitting unit 120 and bonding strength between the wavelength converter 130 and the optical unit 140. For example, the adhesive 260 may include a thermosetting resin, such as a silicone resin, an epoxy resin, or a urethane resin, or may include a UV-curable resin.

In this embodiment, the adhesives 260 are formed between the light emitting unit 120 and the wavelength converter 130 and between the wavelength converter 130 and the optical unit 140, respectively. However, it should be understood that the present invention is not limited thereto. The adhesive 260 may be formed only between the light emitting unit 120 and the wavelength converter 130 or between the wavelength converter 130 and the optical unit 140, as needed.

According to this embodiment, the adhesive 260 can improve the bonding strength between the light emitting unit 120 and the wavelength converter 130 and the bonding strength between the wavelength converter 130 and the optical unit 140, thereby improving reliability of the light emitting device 200.

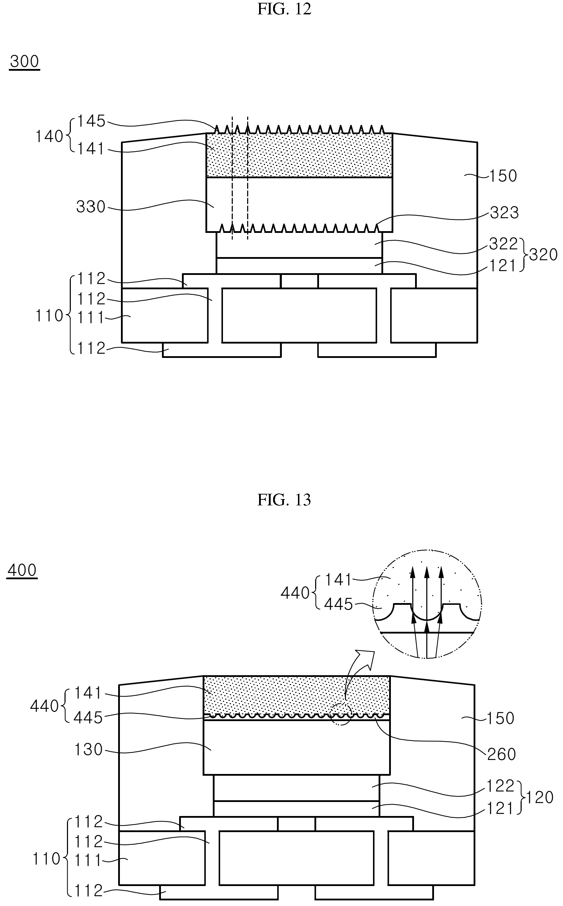

FIG. 12 is a schematic sectional view of a light emitting device according to a third embodiment of the present invention.

Referring to FIG. 12, a light emitting device 300 according to a third embodiment may include a substrate 110, a light emitting unit 320, a wavelength converter 330, an optical unit 140, and a barrier 150.

In the light emitting device 300 according to this embodiment, the light emitting unit 320 has a different structure from the light emitting unit 120 of the light emitting device 100 shown in FIG. 1.

The light emitting unit 320 of the light emitting device 300 according to this embodiment includes a substrate pattern 323 formed on an upper surface of the growth substrate 322. Here, the upper surface of the growth substrate 322 refers to a surface facing the wavelength converter 330 and may constitute a light exit surface of the light emitting unit 320 or a region of the light exit surface thereof.

The substrate pattern 323 formed on the growth substrate 322 has a structure in which a plurality of recess-protrusion structures is arranged. The light exit surface of the light emitting unit 320 has various angles formed by the substrate pattern 323. That is, total internal reflection of light having passed through the growth substrate 322 can be reduced by the interface with various angles. Accordingly, the substrate pattern 323 of the growth substrate 322 can reduce total internal reflection of the light at the light exit surface of the light emitting unit 320 and increase the quantity of light incident on the wavelength converter 330.

According to this embodiment, a pattern may also be formed on a lower surface of the wavelength converter 330 that adjoins the upper surface of the growth substrate 322. As shown in FIG. 12, the lower surface of the wavelength converter 330 may be formed with a pattern that engages with the substrate pattern 323 of the growth substrate 322. When an adhesive 260 (see FIG. 11) is formed between the growth substrate 322 and the wavelength converter 330, a pattern may be formed on a lower surface of the adhesive by the substrate pattern of the growth substrate 322.

Referring to FIG. 12, the substrate pattern 323 of the light emitting unit 320 and the substrate pattern 323 of the optical unit 140 may be disposed offset from each other. For example, a central axis of at least a recess-protrusion structure of the recess-protrusion structures constituting the substrate pattern 323 may be offset from central axes of the recess-protrusion structures constituting the optical pattern 145 placed above the substrate pattern 323. Such a structure can change the light path within the light emitting device 300 in various ways. That is, light can be refracted in various directions by the substrate pattern 323 while passing through the light exit surface of the light emitting unit 320 and can arrive at the light exit surface of the optical unit 140 at various angles, thereby reducing total internal reflection of light at the light exit surface of the optical unit 140. As such, with the structure in which the substrate pattern 323 and the optical pattern 145 are disposed offset from each other, the light emitting device 300 according to the embodiment can achieve improvement in luminous efficacy through reduction in total internal reflection at the light exit surface of the light emitting device 300.

Although FIG. 12 shows the substrate pattern 323 formed on the upper surface of the growth substrate 322 and having a structure in which the plurality of recess-protrusion structures are regularly arranged, it should be understood that the embodiment of the present invention is not limited thereto. Alternatively, the substrate pattern 323 of the growth substrate 322 may have a structure in which the plurality of recesses-protrusion structures are irregularly arranged.

FIG. 13 is a schematic sectional view of a light emitting device according to a fourth embodiment of the present invention.

Referring to FIG. 13, a light emitting device 400 according to a fourth embodiment may include a substrate 110, a light emitting unit 120, a wavelength converter 130, an optical unit 440, and a barrier 150.

In the light emitting device 400 according to this embodiment, the optical unit 440 has a different structure from the optical unit 140 of the light emitting device 100 shown in FIG. 1

In the light emitting device 400 according to this embodiment, the optical unit 440 includes an optical pattern 445 formed on a lower surface thereof. Here, the lower surface of the optical unit 440 including the optical pattern 445 corresponds to a light incidence surface of the optical unit 440 on which light is incident.

According to the embodiment, light emitted from the wavelength converter 130 is incident upon the light incidence surface of the optical unit 440 on which the optical pattern 445 is formed. Here, the optical pattern 445 reduces total internal reflection of light at the light incidence surface of the optical unit 440, thereby improving luminous efficacy of the light emitting device 400. In addition, as the light passes through the optical pattern 445, a traveling direction of the light can be narrowed, instead of spreading, by the angle of the optical pattern on which the light is incident. Accordingly, the light emitting device 400 according to this embodiment can reduce the beam angle through the optical unit 440 including the optical pattern 445 formed on the lower surface thereof, on which light is incident, thereby improving luminance.

Referring to FIG. 13, in this embodiment, the optical pattern 445 is composed of recess-protrusion structures having curved surfaces. However, it should be understood that this embodiment is not limited to the optical pattern 445 including a curved structure. In this embodiment, the optical pattern 445 may be composed of recess-protrusion structures each having a triangular cross-section, as in the above embodiment. Furthermore, the optical pattern 445 of the light emitting device 400 according to other embodiments may also be composed of recess-protrusion structures each having a curved surface.

According to this embodiment, when the adhesive 260 is not interposed, a bonding area between the optical unit 440 and the wavelength converter 130 can be increased by the optical pattern 445 formed on the lower surface of the optical unit 440. Accordingly, bonding strength between the optical unit 440 and the wavelength converter 130 can be increased, thereby improving reliability of the light emitting device 400.

In addition, the light emitting device 400 according to this embodiment may include an adhesive 260 interposed between the wavelength converter 130 and the optical unit 440, as needed. Here, a bonding area between the optical unit 440 and the adhesive 260 can be increased by the optical pattern 445, thereby improving the bonding strength therebetween.

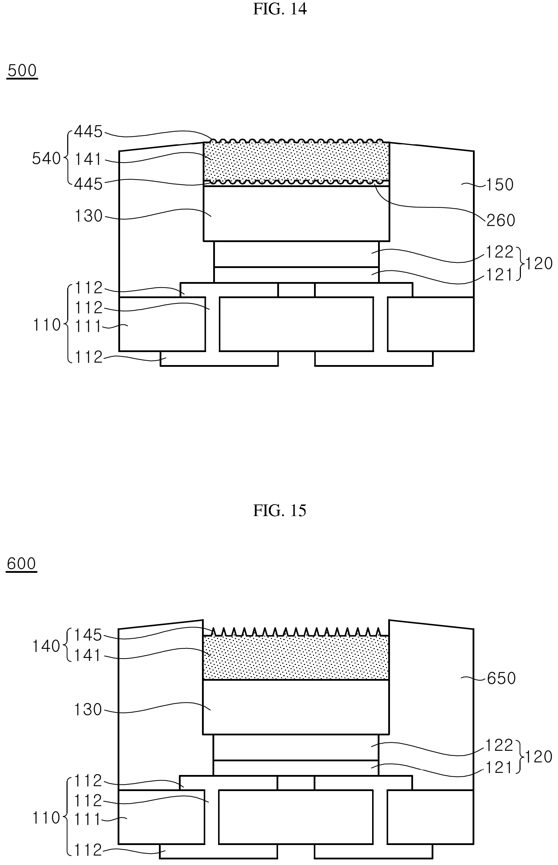

FIG. 14 is a schematic sectional view of a light emitting device according to a fifth embodiment of the present invention.

Referring to FIG. 14, a light emitting device 500 according to a fifth embodiment may include a substrate 110, a light emitting unit 120, a wavelength converter 130, an optical unit 540, and a barrier 150.

In the light emitting device 500 according to this embodiment, the optical unit 540 has a different structure from the optical unit 140 of the light emitting device 100 shown in FIG. 1

In the light emitting device 500 according to this embodiment, the optical unit 540 includes optical patterns 445 formed on both an upper surface and a lower surface of the optical unit 540. Here, the lower surface of the optical unit 540 including the optical pattern 445 corresponds to the light incidence surface of the optical unit 540, and the upper surface of the optical unit 540 including the optical pattern 445 corresponds to a light exit surface of the optical unit 540 and a light exit surface of the light emitting device 500, through which light is emitted.

In addition, although FIG. 14 shows the optical pattern 445 composed of recess-protrusion structures each having a curved surface, the optical pattern 445 may also be composed of recess-protrusion structures each having a triangular cross-section, as shown in FIG. 1.

As in the light emitting device 400 according to the fourth embodiment shown in FIG. 13, the light emitting device 500 according to this embodiment can increase the bonding strength between the optical unit 540 and the adhesive 260 or the wavelength converter 130 disposed under the optical unit 540, can reduce the beam angle thereof, and can increase the luminance thereof through the lower surface of the optical unit 540, on which the optical pattern 445 is formed. Furthermore, the light emitting device 500 according to this embodiment can reduce the beam angle thereof and can increase the luminance thereof through the upper surface of the optical unit 540, on which the optical pattern 445 is formed. That is, the light emitting device 500 according to this embodiment can reduce the beam angle of light on the light incidence surface and the light exit surface of the optical unit 540, thereby improving the luminance thereof.

FIG. 15 is a schematic sectional view of a light emitting device according to a sixth embodiment of the present invention.

Referring to FIG. 15, a light emitting device 600 according to a sixth embodiment may include a substrate 110, a light emitting unit 120, a wavelength converter 130, an optical unit 140, and a barrier 650.

In the light emitting device 600 according to this embodiment, the barrier 650 has a different structure from the barrier 150 of the light emitting device 100 shown in FIG. 1.

Referring to FIG. 1, in the light emitting device 100 according to the first embodiment (see FIG. 1), the upper surface of the barrier 150 is placed collinear with the upper surface of the optical base 141 of the optical unit 140. On the other hand, the barrier 650 of the light emitting device 600 according to this embodiment may be formed such that the upper surface of the barrier 150 is placed higher than the upper surface of the optical unit 140. That is, the upper surface of the barrier 650 according to this embodiment may be placed higher than the optical pattern 145. That is, the upper surface of the barrier 650 may be placed higher than the vertices of the recess-protrusion structures constituting the optical pattern 145.

Although FIG. 15 shows that the upper surface of the barrier 650 is placed higher than the optical pattern 145, it should be understood that this embodiment is not limited thereto. The barrier 650 may be formed such that the upper surface of the barrier 650 is placed lower than the optical pattern 145 and higher than the optical base 141.

In addition, the barrier 650 according to this embodiment may have an inner surface spaced apart from an outer surface of the optical pattern 145, as shown in FIG. 15.

This structure allows light emitted through the outer surface of the optical pattern 145 to be reflected by the inner surface of the barrier 650. The light reflected by the inner surface of the barrier 650 may be emitted from an inner region of the barrier 650 in an upward direction.

Thus, the light emitting device 600 according to this embodiment can reduce the beam angle by preventing light from being emitted from the outer surface of the optical pattern 145 in an outward direction, thereby improving luminance thereof.

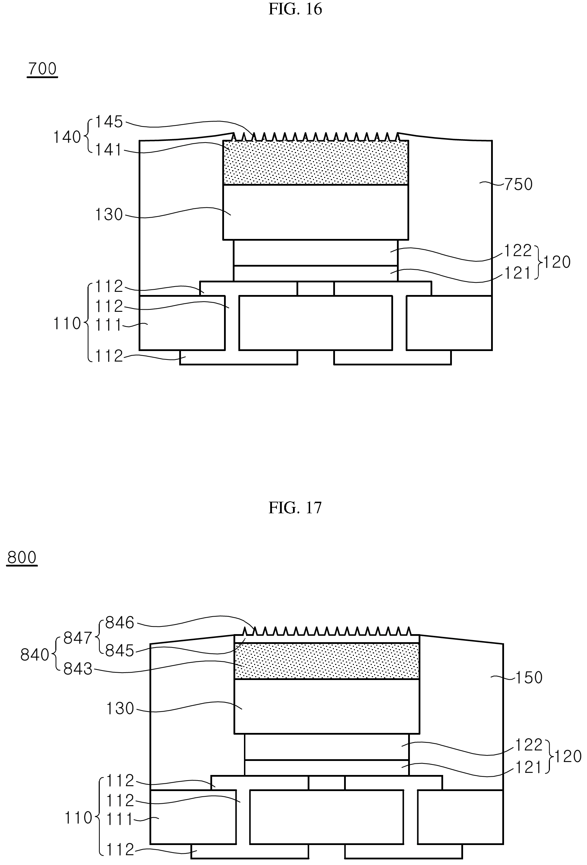

FIG. 16 is a schematic sectional view of a light emitting device according to a seventh embodiment of the present invention.

Referring to FIG. 16, a light emitting device 700 according to a seventh embodiment may include a substrate 110, a light emitting unit 120, a wavelength converter 130, an optical unit 140, and a barrier 750.

In the light emitting device 700 according to this embodiment, the barrier 750 has a different structure from the barrier 150 of the light emitting device 100 shown in FIG. 1.

An upper surface of the barrier 750 according to this embodiment has a variable height. Referring to FIG. 16, the upper surface of the barrier 750 may have a height gradually increasing from an outer side of the barrier 750 to an inner side thereof. In addition, the barrier 750 may have an end formed to cover at least a region of a side surface of the optical pattern 145 of the optical unit 140. Here, an end of the upper surface of the barrier 750 is placed inside the barrier 750 and adjoins the optical unit 140. Here, the barrier 750 may be formed to cover an outer surface of the optical pattern 145 adjacent to the periphery of the upper surface of the optical base 141. That is, the barrier 750 may cover outer surfaces of recess-protrusion structures adjacent to the periphery of the upper surface of the optical unit 140 among the recess-protrusion structures constituting the optical pattern 145. The optical unit 140 may be formed to cover the entirety of the outer surface of the optical pattern 145 to adjoin the vertices of the optical pattern 145. Alternatively, the optical unit 140 may be formed to cover a region of the outer surface of the optical pattern 145 such that an end of the upper surface of the optical unit is placed lower than the vertices of the optical pattern 145.

Such a structure allows light emitted through the outer surface of the optical pattern 145 to be reflected by the barrier 750. That is, the barrier 750 covering the outer surface of the optical pattern 145 can prevent light from being emitted through the outer surface of the optical pattern 145 in a lateral direction.

Thus, the light emitting device 700 according to this embodiment can reduce the beam angle by preventing light from being emitted from the outer surface of the optical pattern 145 in an outward direction, thereby improving luminance thereof.

FIG. 17 is a schematic sectional view of a light emitting device according to an eighth embodiment of the present invention.

Referring to FIG. 17, a light emitting device 800 according to an eighth embodiment may include a substrate 110, a light emitting unit 120, a wavelength converter 130, an optical unit 840, and a barrier 150.

In the light emitting device 800 according to this embodiment, the optical unit 840 has a different structure from the optical unit 140 of the light emitting device 100 shown in FIG. 1

According to this embodiment, the optical unit 840 may include a first optical unit 843 and a second optical unit 847. The first optical unit 843 may be formed on top of the wavelength converter 130 and the second optical unit 847 may be formed on top of the first optical unit 843. The first optical unit 843 may include an optical base on which an optical pattern is not formed. In addition, an optical pattern 846 may be formed on the second optical unit 847. That is, the second optical unit 847 may include a second optical base 845 and the optical pattern 846 formed on an upper surface of the second optical base 845.

The first optical unit 843 and the second optical unit 847 may be formed of a light transmissive material, such as sapphire, a silicone resin, glass, ceramics, alumina, or a urethane. In addition, the first optical unit 843 and the second optical unit 847 may be formed of different materials. Here, the beam angle of the light emitting device 800 can be reduced through difference in index of refraction due to a material difference between the first optical unit 843 and the second optical unit 847.

For example, the first optical unit 843 may be formed of a silicone resin and the second optical unit 847 may be formed of glass. Alternatively, the first optical unit 843 may be formed of glass and the second optical unit 847 may be formed of a silicone resin.

In another example, the first optical unit 843 and the second optical unit 847 may be formed of the same material and may have different indices of refraction due to difference in internal material therein. A unit of the first optical unit 843 and the second optical unit 847 may further include an internal material, such as a wavelength conversion material, a diffusion material, and the like. Alternatively, the first optical unit 843 and the second optical unit 847 may include different internal materials. For example, a unit of the first optical unit 843 and the second optical unit 847 may include a wavelength conversion material and the other may include a diffusion material. Alternatively, the first optical unit 843 and the second optical unit 847 may include different types of wavelength conversion materials or wavelength conversion materials having different light spectra. More specifically, the first optical unit 843 may include green or yellow phosphors and the second optical unit 847 may include red phosphors.

In addition, the second optical unit 847 may be thinner than the first optical unit 843. By forming the second optical unit 847 thinner than the first optical unit 843, the light emitting device 800 can reduce light loss due to light absorption in the second optical unit 847, thereby increasing the quantity of light of the light emitting device 800.

In this embodiment, the optical pattern 846 is formed only on the upper surface of the second optical unit 847. However, it should be understood that this embodiment is not limited thereto. The optical pattern 846 may be formed on at least a surface of a lower surface of the second optical unit 847, an upper surface of the first optical unit 843, and a lower surface of the first optical unit 843.

In the light emitting devices 100, 200, 300, 400, 500, 600, 700 described with reference to FIG. 1 and FIG. 11 to FIG. 17, the optical pattern has a structure in which the side surface of the optical pattern is composed of a single plane in cross-sectional view. More specifically, each of the side surfaces of the recess-protrusion structures constituting the optical pattern is composed of a single plane. However, it should be understood that the structure of the optical pattern is not limited thereto. The optical pattern may be formed in various structures by applying various etching factors, such as the number of etching processes, the selection ratio, the type of etchant, and the like. For example, the optical pattern may be composed of recess-protrusion structures composed of planes with different inclinations at a side thereof.

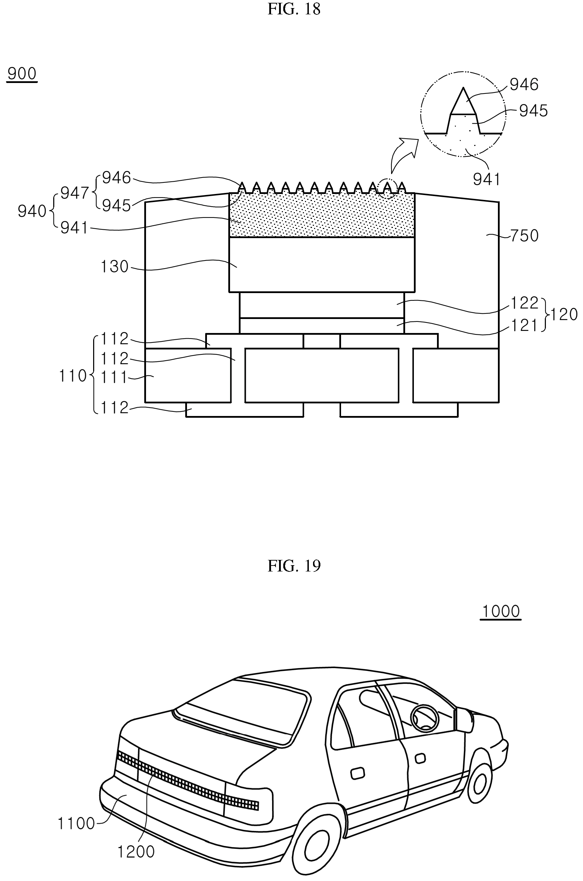

FIG. 18 is a schematic sectional view of a light emitting device according to a ninth embodiment of the present invention.

Referring to FIG. 18, a light emitting device 900 according to a ninth embodiment may include a substrate 110, a light emitting unit 120, a wavelength converter 130, an optical unit 940, and a barrier 150.

In the light emitting device 900 according to this embodiment, the optical unit 940 has a different structure from the optical unit 140 of the light emitting device 100 shown in FIG. 1

According to this embodiment, the optical unit 940 includes an optical base 941 and an optical pattern 947 formed on top of the optical base 941. In addition, the optical pattern 947 of the optical unit 940 may include a first optical pattern 945 and a second optical pattern 946.

The first optical pattern 945 is formed of the same material as the optical base 941. In addition, the first optical pattern 945 is integrally formed with the optical base 941. That is, the first optical pattern 945 may be formed by partially etching an upper surface of the optical base 941.

The second optical pattern 946 is formed on top of the first optical pattern 945. The second optical pattern 946 may be formed of a different material than the first optical pattern 945 and the optical base 941.

The optical pattern 947 according to this embodiment may be formed through an etching process after forming a second optical base on top of a first optical base. The first optical base and the second optical base may be formed of different materials. Through the etching process, the upper surface of the first optical base under the second optical base may also be partially etched. A remaining region of the second optical base after etching may become the second optical pattern 946. Further, a remaining upper region of the first optical base placed under the second optical pattern 946 and subjected to etching may become the first optical pattern 945. Further, a region of the first optical base placed under the first optical pattern 945 may become the optical base 941 of the optical unit 940 according to this embodiment.

According to this embodiment, since the first optical base and the second optical base include different materials, the first optical pattern 945 and the second optical pattern 946 may be formed in different shapes depending on various factors, such as etching profile, etching rate, and the like during the etching process. For example, as shown in FIG. 18, the first optical pattern 945 and the second optical pattern 946 may be formed to have side surfaces with different inclinations. For example, as shown in FIG. 18, the side surface of the second optical pattern 946 has a smaller inclination relative to the upper surface of the optical base 941 than the side surface of the first optical pattern 945.

As such, the light emitting devices according to various embodiments of the present invention described above can reduce the beam angle of light through the light exit surface formed with the pattern, thereby enabling precise light control of lighting devices and displays. Furthermore, the light emitting devices can emit light at a narrow beam angle to improve luminance. For example, the light emitting device according to this embodiment may be applied to a device that requires a narrow beam angle and high luminance in a certain area, such as a headlamp of an automobile that requires a narrow beam angle. Furthermore, the light emitting device according to this embodiment having a narrow beam angle and high luminance may be applied to a head mounted display (HMD) to provide a clear image to a user despite a short distance between a display device and the eyes of the user.

FIG. 19 is an exemplary view of a vehicle including a light emitting device according to an embodiment of the present invention.

Referring to FIG. 19, a vehicle 1000 includes a main body 1100 and a lamp 1200 mounted to the main body. The lamp 1200 requires control of a light emitting region for directional guidance or adjustment of a projection region. Accordingly, at least a light emitting device among the light emitting devices 100 to 900 according to the embodiments described with reference to FIG. 1 to FIG. 18 may be used as a light source for the lamp 1200.

According to this embodiment, the lamp 1200 may include a plurality of light emitting devices arranged thereon. In addition, the lamp 1200 may control the plurality of light emitting devices to individually operate each of the plurality of light emitting devices. Thus, the lamp 1200 can easily adjust the light emitting region or the projection region by independently controlling the plurality of light emitting devices each having a narrow beam angle.

In this embodiment, the light emitting device includes both the wavelength converter and the light emitting unit. However, it should be understood that the present invention is not limited thereto. That is, the light emitting device may include a light transmitting unit free from a wavelength conversion material, instead of the wavelength converter. In addition, when a plurality of light emitting devices is provided as in the lamp, at least a light emitting device of the light emitting devices may include a light transmitting unit free from a wavelength conversion material, instead of the wavelength converter. That is, according to this embodiment, a lamp comprising a plurality of light emitting devices may include a structure in which the plurality of light emitting units is arranged and a structure in which the wavelength converter covers at least a region of plurality of light emitting units.

Although some embodiments have been described herein with reference to the accompanying drawings, it should be understood that the foregoing embodiments are provided for illustration only and are not to be in any way construed as limiting the scope of the present invention. The scope of the present invention should be defined by the appended claims and equivalents thereto.

## Claims

1. A light emitting device comprising:
a substrate;
a light emitting unit disposed on the substrate;
a wavelength converter disposed on the light emitting unit;
an optical unit disposed on the wavelength converter; and
a barrier disposed on the substrate and covering side surfaces of the light emitting unit, the wavelength converter, and the optical unit,
wherein the optical unit comprises an optical base and an optical pattern comprising recess-protrusion structures formed on at least a surface of the optical base.

2. The light emitting device according to claim 1, wherein the optical pattern is formed on an upper surface of the optical base.

3. The light emitting device according to claim 1, wherein the optical pattern is formed on a lower surface of the optical base.

4. The light emitting device according to claim 1, wherein the optical unit comprises a first optical unit and a second optical unit disposed on the first optical unit,
at least one of the first optical unit and the second optical unit comprising at least a material different from that of the other, and
the optical pattern is formed on an upper surface of a second optical base of the second optical unit.

5. The light emitting device according to claim 1, wherein the optical pattern comprises a first optical pattern formed on an upper surface of the optical base and a second optical pattern formed on an upper surface of the first optical pattern,
the first optical pattern and the second optical pattern being formed of different materials.

6. The light emitting device according to claim 5, wherein the first optical pattern and the second optical pattern comprise side surfaces with different inclinations in cross-sectional view.

7. The light emitting device according to claim 5, wherein the optical base and the first optical pattern are formed of the same material and are integrally formed with each other.

8. The light emitting device according to claim 1, wherein a side surface of the optical pattern comprises planes having different inclinations in cross-sectional view.

9. The light emitting device according to claim 1, wherein an adhesive is formed in at least one of a region between the light emitting unit and the wavelength conversion material or a region between the wavelength conversion material and the optical unit.

10. The light emitting device according to claim 1, wherein an upper surface of the barrier is placed collinear with an upper surface of the optical base.

11. The light emitting device according to claim 1, wherein an upper surface of the barrier is placed higher than the optical pattern.

12. The light emitting device according to claim 1, wherein an upper surface of the barrier has a height gradually increasing from an outer side of the barrier to an inner side thereof.

13. The light emitting device according to claim 12, wherein the barrier covers an outer surface of the optical pattern adjacent to a periphery of an upper surface of the optical base.

14. The light emitting device according to claim 1, wherein the barrier comprises a light reflective material.

15. The light emitting device according to claim 1, wherein the light emitting unit comprises a growth substrate formed to face the wavelength converter, and
wherein refractive indices of the growth substrate of the light emitting unit, the wavelength converter, and the optical unit decrease in this order.

16. The light emitting device according to claim 1, wherein the light emitting device has a narrower beam angle than the light emitting unit.

17. The light emitting device according to claim 1, wherein the light emitting device has a beam angle of 60 degrees to 100 degrees.

18. A light emitting device comprising:
a substrate;
a light emitting unit disposed on the substrate;
a wavelength converter disposed on the light emitting unit;
an optical unit disposed on the wavelength converter; and
a barrier disposed on the substrate to cover side surfaces of the light emitting unit, the wavelength converter and the optical unit,
wherein the optical unit comprises a first optical unit and a second optical unit disposed on the first optical unit,
the second optical unit comprising a second optical base disposed on the first optical unit and an optical pattern formed on an upper surface of the second optical base.

19. The light emitting device according to claim 18, wherein at least one of the first optical unit and the second optical unit comprises at least a material different from that of the other.

20. A vehicular lamp comprising:
a main body; and
a lamp mounted on at least a surface of the body, the lamp comprising:
a plurality of light emitting units arranged thereon;
a wavelength converter covering an upper surface of at least a light emitting unit of the light emitting units; and
an optical unit comprising an optical pattern composed of recess-protrusion structures formed on at least a surface of the optical unit,
wherein each of the plurality of light emitting units is independently driven.
